# EUROPEAN PATENT APPLICATION

(11) **EP 2 363 899 A2**
(43) Date of publication of application: **07.09.2011**
(21) Application number: 11156562.8
(22) Date of filing: 02.03.2011
(51) Int. Cl.: H01L 41/18

(54) **Piezoelectric film, piezoelectric device, liquid ejection apparatus, and method of producing piezoelectric film**

(30) Priority: 03.03.2010 JP 2010046802
(71) Applicant: Fujifilm Corporation, Minato-ku Tokyo 106-8620 (JP)
(72) Inventor: Naono, Takayuki, Kanagawa-ken (JP)
(74) Representative: HOFFMANN EITLE

(57) **Abstract**

A piezoelectric film (13) is formed on a surface of a substrate (12) by a vapor deposition process without generating grain boundaries which are substantially parallel to the surface of the substrate (L2) and are caused by lamination. A normal of a (100) plane of each of crystals constituting the piezoelectric film (13) is inclined from a normal of the surface of the substrate (12) by an angle of not smaller than 6° and not larger than 36°.

## Description

### BACKGROUND OF THE INVENTION

### Field of the Invention

The present invention relates to a piezoelectric film, a piezoelectric device, a liquid ejection apparatus, and a method of producing a piezoelectric film, more particularly to a piezoelectric film with improved durability in continuous driving, a piezoelectric device including the piezoelectric film, a liquid ejection apparatus including the piezoelectric device, and a method of producing the piezoelectric film.

### Description of the Related Art

There has been known a piezoelectric device that is obtained by combining a piezoelectric film having a piezoelectric property displaced by application of a drive voltage, with electrodes through which the drive voltage is applied to the piezoelectric film.

Japanese Patent Application Publication No. 11-307833, for example, describes a piezoelectric device in which the (100) orientation in the crystal forming a piezoelectric film is inclined by 5° to 20°. Inclining the (100) orientation by 5° to 20° provide not only good piezoelectric properties at low voltage but also piezoelectric properties that are higher than those of the prior art within a certain voltage range.

Japanese Patent Application Publication No. 2008-277672 describes a piezoelectric device including a piezoelectric film containing a ferroelectric phase in which an angle θm formed by an electric field application direction and a normal of a plane determined by the spontaneous polarization axis and the [010] axis satisfies -45° < θm < +45 and θm ≠ 0°. According to this, the piezoelectric device has the piezoelectric film with high piezoelectric performance.

However, in a PZT (lead titanate zirconate) film in the related art, leakage associated with grain boundaries and formation of defects occur during continuous driving of the PZT film, causing insulation breakdown. Moreover, it is known that a large amount of Pb (lead) in the PZT film easily induces migration of Pb ions in the course of repeatedly applying the drive voltage, causing an arcing phenomenon.

The piezoelectric device described in Japanese Patent Application Publication No. 11-307833 is produced exclusively by a sol-gelation process; however, the problems in producing piezoelectric devices using the sol-gelation process include not being able to make films thick, irregular composition in the depth direction of the films, and poor production efficiency (slow film formation speed).

When a piezoelectric film is used in an inkjet device, it is desirable that the thickness of the piezoelectric film is not smaller than 2 µm in order to improve ejection efficiency. However, producing a PZT film of at least 2 µm thickness by using the sol-gelation process might cause cracks on the PZT film, due to thermal stress resulting from a repetition of coating and sintering steps. Therefore, it is difficult to produce a PZT film of at least 2 µm thickness by using the sol-gelation process. Moreover, use of the sol-gelation process to produce a PZT film causes horizontal stripes each time sintering crystallization is performed, and when piezoelectric crystals repeatedly perform the functions associated with the piezoelectric effects, the stripe defects originate cracks, resulting in lowering the durability.

### SUMMARY OF THE INVENTION

The present invention has been contrived in view of these circumstances, an object thereof being to provide a piezoelectric film capable of withstanding long-term driving, a piezoelectric device including the piezoelectric film, a liquid ejection apparatus including the piezoelectric device, and a method of producing the piezoelectric film.

In order to attain the aforementioned object, the present invention is directed to a piezoelectric film which is formed on a surface of a substrate by a vapor deposition process without generating grain boundaries which are substantially parallel to the surface of the substrate and are caused by lamination, wherein a normal of a (100) plane of each of crystals constituting the piezoelectric film is inclined from a normal of the surface of the substrate by an angle of not smaller than 6° and not larger than 36°.

According to this aspect of the present invention, forming the piezoelectric film by means of the vapor deposition process prevents formation of cracks that are caused by thermal stress resulting from a repetition of the lamination and crystallization heating steps, unlike the formation of a piezoelectric film using the sol-gelation process. Moreover, the durability of the piezoelectric film can be improved because insulation breakdown that can be caused by horizontal stripes formed by the repetition of the lamination and crystallization steps does not occur. Furthermore, the driving durability of the piezoelectric film can be improved by inclining the normal of the (100) plane of each of the crystals from the normal of the surface of the substrate by the angle of not smaller than 6° and not larger than 36°.

Preferably, a thickness of the piezoelectric film is not smaller than 2 µm and not larger than 20 µm.

According to this aspect of the present invention, the durability of the piezoelectric film can be improved by confining the thickness of the piezoelectric film in the above-mentioned range. If the piezoelectric film is thinner than 2 µm, sufficient durability cannot be obtained, and if the piezoelectric film is thicker than 20 µm, the thick piezoelectric film can be easily broken by stress.

Preferably, the piezoelectric film has a columnar crystal structure extending in a thickness direction of the piezoelectric film.

According to this aspect of the present invention, an oriented film with a uniform crystal orientation can be obtained, and thereby high piezoelectric performance can be achieved.

Preferably, the piezoelectric film has a piezoelectric constant d₃₁ of not smaller than 200 pC/N.

According to this aspect of the present invention, sufficient piezoelectric performance can be obtained.

Preferably, the piezoelectric film includes at least one perovskite oxide represented by ABO₃, where A represents at least one element which occupies an A-site and is selected from a group consisting of Pb, Ba, La, Sr, Bi, Li, Na, Ca, Cd, Mg and K; B represents at least one element which occupies a B-site and is selected from a group consisting of Ti, Zr, V, Nb, Ta, Sb, Cr, Mo, W, Mn, Sc, Co, Cu, In, Sn, Ga, Zn, Cd, Fe and Ni; O represents oxygen; and a molar ratio of A:B:O is within a range where a perovskite structure is obtained and 1:1:3 is a standard.

It is also preferable that the piezoelectric film includes at least one perovskite oxide represented by ABO₃, where A represents at least one element which occupies an A-site and includes Pb; B represents at least one element which occupies a B-site and is selected from a group consisting ofTi, Zr, V, Nb, Ta, Sb, Cr, Mo, W, Mn, Sc, Co, Cu, In, Sn, Ga, Zn, Cd, Fe and Ni; O represents oxygen; and a molar ratio of A:B:O is within a range where a perovskite structure is obtained and 1:1:3 is a standard.

It is also preferable that the piezoelectric film includes at least one perovskite oxide represented by Aₐ(Zrₓ, Ti_{y}, M_{b-x-y})_{b}O_{c}, where A represents at least one element which occupies an A-site and includes Pb; M represents at least one metal element; 0 < x < b, 0 < y < b, 0 ≤ (b - x - y); and a ratio of a:b:c is within a range where a perovskite structure is obtained and 1:1:3 is a standard.

According to these aspects of the present invention, by using the above-mentioned perovskite oxide, the piezoelectric film having sufficient piezoelectric performance can be obtained.

Preferably, the Pb component a occupying the A-site is less than 1.10.

According to this aspect of the present invention, the durability of the piezoelectric film can be improved. If the Pb component a is 1.10 or above, a driving electric field induces migration of Pb ions, causing a breaking mode in which arcing easily occurs, and thereby the durability drops significantly.

Preferably, the vapor deposition process uses plasma.

It is also preferable that the vapor deposition process includes a sputtering process.

According to these aspects of the present invention, the formation of the horizontal stripes caused by the repetition of the lamination and crystallization can be prevented effectively, and the piezoelectric film having the columnar crystal structure can be obtained.

In order to attain the aforementioned object, the present invention is also directed to a piezoelectric device, comprising: the above-described piezoelectric film; and electrodes through which an electric field is applied to the piezoelectric film.

In order to attain the aforementioned object, the present invention is also directed to a liquid ejection apparatus, comprising: the above-described piezoelectric device; and a liquid ejection member which is arranged adjacent to the piezoelectric device and includes: a liquid storing chamber which stores liquid; and a liquid ejection port through which the liquid is ejected from the liquid storing chamber in response to an application of the electric field to the piezoelectric film.

According to these aspects of the present invention, the use of the above-described piezoelectric film can provide the piezoelectric device and the liquid ejection apparatus that are capable of withstanding a long-term use.

In order to attain the aforementioned object, the present invention is also directed to a method of producing a piezoelectric film, comprising the step of forming a piezoelectric film on a surface of a substrate by a vapor deposition process, the piezoelectric film having a columnar crystal structure in which a normal of a (100) plane of each of crystals constituting the piezoelectric film is inclined from a normal of the surface of the substrate by an angle of not smaller than 6° and not larger than 36°.

According to this aspect of the present invention, unlike a piezoelectric film formed by the sol-gelation process, the piezoelectric film formed by the vapor deposition process can be thick without causing the horizontal stripes. Moreover, formation of cracks that are originated due to the horizontal stripes can be prevented, and consequently the durability can be improved.

Moreover, compositional variations in the depth direction of the piezoelectric film can be suppressed so as to produce the piezoelectric film with high performance. While the sol-gelation process provides poor productivity due to a repetition of the coating, defatting, and sintering steps, the vapor deposition process can improve the production efficiency due to the increased film formation speed.

Preferably, the vapor deposition process uses plasma.

It is also preferable that the vapor deposition process includes a sputtering process.

According to these aspects of the present invention, the formation of the horizontal stripes caused by the repetition of the lamination and crystallization can be prevented effectively, and the piezoelectric film having the columnar crystal structure can be obtained.

According to the piezoelectric film of the present invention, the normal of the (100) plane of each of the crystals constituting the piezoelectric film is inclined by a predetermined angle with respect to the normal direction of the surface of the substrate, in which is a driving electric field is applied. Therefore, the driving durability can be improved. Moreover, the use of the vapor deposition process can produce a thick piezoelectric film without causing cracks. The driving durability can be further improved since no irregular lamination occurs and formation of defects due to use of the piezoelectric film can be prevented.

### BRIEF DESCRIPTION OF THE DRAWINGS

The nature of this invention, as well as other objects and advantages thereof, will be explained in the following with reference to the accompanying drawings, in which like reference characters designate the same or similar parts throughout the figures and wherein:
Fig. 1 is a cross-sectional diagram showing a structure of a piezoelectric device having a piezoelectric film and a structure of an inkjet recording head according to an embodiment of the present invention;
Fig. 2 is a schematic configuration diagram of an inkjet recording apparatus having the inkjet recording head shown in Fig. 1;
Fig. 3 shows a result of ω scan measurement performed on a piezoelectric film of Example 1 by means of XRD;
Fig. 4 shows a TEM cross-sectional image of the piezoelectric film of Example 1:
Fig. 5 is a table showing the results obtained by experiments; and
Fig. 6 shows a result of ω scan measurement performed on a piezoelectric film of Comparative Example 1 by means of XRD

### DETAILED DESCRIPTION OF THE PREFERRED EMBODIMENTS

### Piezoelectric device and inkjet recording head

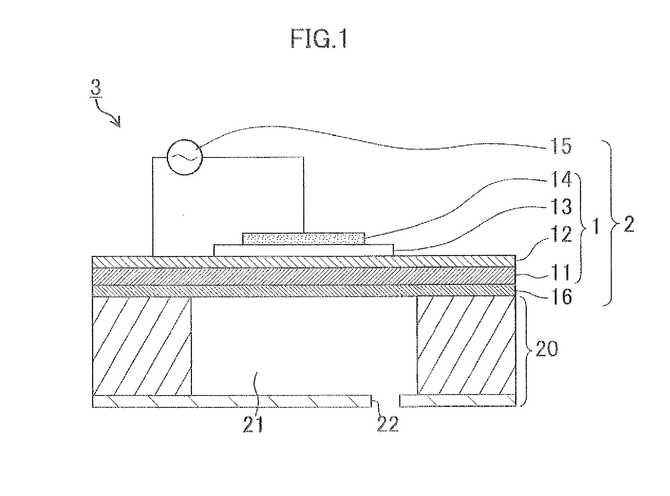

A structure of a piezoelectric device having a piezoelectric film according to an embodiment of the present invention and a structure of an inkjet recording head (liquid ejection apparatus) are described with reference to Fig. 1. Fig. 1 is a cross-sectional diagram showing substantial parts of the inkjet recording head. In order to facilitate visualization of the components of the inkjet recording head, the scales of the components in the drawing are made different appropriately to each other.

Schematically, the inkjet recording head (liquid ejection apparatus) 3 of the present embodiment includes a piezoelectric actuator 2 and an ink nozzle (liquid storing and ejecting member) 20 attached to a lower surface of the piezoelectric actuator 2 in the drawing. The ink nozzle 20 has an ink chamber (liquid storing chamber) 21, which stores ink, and an ink ejection port (liquid ejection port) 22, through which the ink ejected from the ink chamber 21 to the outside.

In the inkjet recording head 3, the intensity of an electric field applied to a piezoelectric device 1 is changed so as to expand or contract the piezoelectric device 1, and thereby the ejection timing and the ejection amount of the ink from the ink chamber 21 are controlled.

The piezoelectric actuator 2 is formed by attaching a diaphragm 16 to a lower surface of a substrate 11 of the piezoelectric device 1 in the drawing. The diaphragm 16 vibrates as a piezoelectric film 13 expands and contracts.

In place of attaching the diaphragm 16 and the ink nozzle 20 as the members independent from the substrate 11, a part of the substrate 11 can be processed into the diaphragm 16 and the ink nozzle 20. For instance, the substrate 11 can be etched, starting from the lower surface thereof in the drawing, in order to form the ink chamber 21, and then the diaphragm 16 and the ink nozzle 20 can be formed by processing the substrate 11 itself.

The piezoelectric device 1 is formed by sequentially placing a lower electrode layer 12, the piezoelectric film 13, and an upper electrode layer 14 on an upper surface of the substrate 11 in the drawing. An electric field is applied to the piezoelectric film 13 in a thickness direction thereof by the lower electrode layer 12 and the upper electrode layer 14.

The piezoelectric actuator 2 is in a flexural vibration mode. The lower electrode layer 12 is subjected to patterning along with the piezoelectric film 13 such that the drive voltage can be changed for each ink chamber 21. The piezoelectric device 1 also has a driver 15 that performs drive control for changing the voltage applied to the lower electrode layer 12.

The substrate I of the piezoelectric device 1 according to the present embodiment is not particularly limited, and examples of the material of the substrate 11 include silicon, glass, stainless steel (SUS), yttria-stabilized zirconia (YSZ), SrTiO₃, alumina, sapphire, and silicon carbide. A laminated substrate, such as an SOI substrate formed by sequentially placing a SiO₂ film and a Si active layer on a silicon substrate, can be used as the substrate 11. Furthermore, between the substrate 11 and the lower electrode layer 12, a buffer layer for improving the lattice matching properties or an adhesion layer for enhancing the adhesion between the substrate and the electrode can be arranged.

Examples of the major constituents of the lower electrode layer 12 include, but not limited to, the metals or metal oxides such as Au, Pt, Ir, IrO₂, RuO₂, LaNiO₃, and SrRuO₃, and combinations thereof.

Examples of the major constituents of the upper electrode layer 14 include, but not limited to, the examples of the major constituents of the lower electrode layer 12 described above, electrode materials such as Al, Ta, Cr and Cu that are generally used in a semiconductor device, and combinations thereof.

The thicknesses of the lower electrode layer 12 and the upper electrode layer 14 are preferably, but not limited to, 50 nm to 500 nm.

A normal of a (100) plane of each of crystals constituting the piezoelectric film 13 is inclined from a normal of the surface of a substrate by an angle of not smaller than 6° and not larger than 36°. By adjusting the inclination angle of the normal of the (100) plane of each of crystals with respect to the normal of the substrate surface within 6° to 36°, it is possible to realize high driving durability of the piezoelectric film 13. More preferably, the inclination angle is not smaller than 10° and not larger than 17°. The inclination angle can be measured by means of XRD (X-ray diffraction) analysis. Specifically, the inclination angle can be obtained by performing 2θ-fixed ω scanning in the XRD measurement.

The piezoelectric film 13 is composed of one or more kinds of perovskite oxides represented by ABO₃, where A represents at least one element which occupies an A-site and is selected from a group consisting of Pb, Ba, La, Sr, Bi, Li, Na, Ca, Cd, Mg and K, and preferably at least one element including Pb; B represents at least one element which occupies a B-site and is selected from a group consisting of Ti, Zr, V, Nb, Ta, Sb, Cr, Mo, W, Mn, Sc, Co, Cu, In, Sn, Ga, Zn, Cd, Fe and Ni; O represents oxygen; and a molar ratio of A:B:O is within a range where a perovskite structure is obtained and 1:1:3 is a standard.

Examples of the perovskite oxides expressed by the general formula ABO₃ include lead titanate, lead titanate zirconate (PZT), lead zirconate, lead lanthanum titanate, lead lanthanum titanate zirconate, zirconium magnesium niobate-lead titanate, and zirconium nickel niobate-lead titanate.

The piezoelectric film 13 can be composed of mixed crystals of two or more kinds of the perovskite oxides expressed by the general formula ABO₃.

It is particularly preferable that the piezoelectric film 13 is composed of one or more kinds of perovskite oxides represented by Aₐ(Zrₓ, Ti_{y}, M_{b-x-y})_{b}O_{c}, where A represents at least one element which occupies an A-site and includes Pb; M represents at least one metal element; 0 < x < b, 0 < y < b, 0 ≤ (b - x - y); and a ratio of a:b:c is within a range where a perovskite structure is obtained and 1:1:3 is a standard.

It is preferable that the Pb component a occupying the A-site in Aₐ(Zrₓ, Ti_{y}, M_{b-x-y})_{b}O_{c} (i.e., "a" in A_{"a"}(Zrₓ, Ti_{y}, M_{b-x-y})_{b}O_{c}) is less than 1.10. When the Pb component a occupying the A-site is 1.10 or above, a driving electric field induces migration of Pb ions, causing a breaking mode in which arcing easily occurs, and thereby the durability drops significantly. Therefore, it is preferable that the Pb component a is controlled to be less than 1.10. The Pb component a can be controlled to be less than 1.10 by controlling a film formation temperature, substrate potential, and film formation power. The Pb component a can be measured by means of X-ray fluorescence (XRF) analysis.

The inclination angle of the normal of the (100) plane of each of crystals constituting the piezoelectric film 13 with respect to the normal of the substrate surface can be controlled by changing the component occupying the A-site in the perovskite oxide.

It is preferable that the piezoelectric film 13 is a columnar crystal structure film constituted of many columnar crystals extending in a direction non-parallel to the substrate surface, and thereby high piezoelectric performance can be achieved. The film structure composed of the columnar crystals extending in the direction non-parallel to the substrate surface, can obtain an oriented film having a uniform crystal orientation. Such a film structure can be obtained when forming a film by means of a sputtering method or other non-thermal equilibrium process.

The average column diameter of the columnar crystals constituting the piezoelectric film 13 is preferably, but not limited to, not smaller than 30 nm and not larger than 1 µm. If the average column diameter of the columnar crystals is too small, sufficient crystal growth might not occur in the piezoelectric film, and desired piezoelectric performance might not be accomplished. If the average column diameter of the columnar crystals is too large, on the other hand, the accuracy of the shape obtained after patterning might be lowered.

It is preferable that the thickness of the piezoelectric film 13 to be formed is not smaller than 2 µm and not larger than 20 µm. Making the piezoelectric film thick can provide high durability. Because the piezoelectric film 13 according to the present embodiment is formed by means of the vapor deposition process, the piezoelectric film with the above-mentioned thickness range can be formed without causing grain boundaries. When the sol-gelation process is used for the film formation, the coating and sintering operations need to be repeated a number of times in order to obtain the thick film. The repetition of the operations might generate horizontal stripes in the piezoelectric film, and hence cracks resulting from the use of the piezoelectric film. The horizontal stripes indicate grain boundaries which are substantially parallel to the surface of the substrate and are caused by lamination. The cracks might occur due to thermal stress resulting from the repetition of the coating and sintering operations.

Because the piezoelectric film 13 according to the present embodiment is formed by means of the vapor deposition process, cracks that are caused by thermal stress and cracks that are originated due to the stripe defects can be prevented from occurring, and thus the piezoelectric film with high durability can be obtained.

The use of the vapor deposition process for the film formation can suppress a periodic composition variation that is observed in the film formation using the sol-gelation process. Therefore, not only stress but also decrease in performance caused by the film performance distribution in the depth direction of the piezoelectric film can be suppressed, resulting in the piezoelectric film with high performance.

Since the sol-gelation process performs the film formation by repeating the coating, defatting, and sintering steps, the thickness of the film formed per coating is approximately 100 nm. Forming a thick piezoelectric film by repeating these operations is extremely time-consuming. The use of the vapor deposition process can perform the film formation at a speed of 4 µm/h, improving the production efficiency. Moreover, the film-formation speed can be raised easily by increasing the input power.

### Film formation method

Examples of the method of forming (producing) the piezoelectric film include a sputtering method, ion plating method, plasma CVD (chemical vapor deposition) method, PLD (pulsed laser deposition) method, and other vapor deposition processes using plasma. Above all, the sputtering method or other non-thermal equilibrium process can produce a film having a columnar crystal structure.

According to the embodiment of the present invention, controlling the conditions under which the piezoelectric film formed can obtain a laminated structure in which the normal of the (100) plane of each of the crystals constituting the piezoelectric film is inclined by an inclination angle of not smaller than 6° and not larger than 36° with respect to the normal of the substrate surface. If the inclination angle is larger than 36°, the proportion of the perovskite (112) plane increases and the piezoelectric performance declines.

The present inventor has discovered that the normal of the (100) plane of each of the crystals can be inclined by increasing the energy of sputtered particles contributing to crystal growth, to above a certain level, when forming the piezoelectric film using the sputtering method. For example, the energy of the sputtered particles migrating on the surface of the substrate is increased by raising a substrate temperature T. The energy of the sputtered particles reaching the substrate can be increased by lowering a film formation pressure P, a target-substrate distance (T-S distance), and substrate potential V_{sub}.

Based on this principle, the inclination angle can be adjusted by adjusting the substrate temperature T, the film formation pressure P, the target-substrate distance (T-S distance), and the substrate potential V_{sub} that serve as the parameters for the sputtering film formation. Specifically, in order to incline the normal of the (100) plane of each of the crystals by the inclination angle of not smaller than 6° and not larger than 36° with respect to the normal of the substrate surface, it is preferable that the piezoelectric film is formed within the following ranges.

When the A-site is not doped with anything other than Pb:
0.1 ≤ (Pa) ≤ 0.3;
T-S distance (mm) = 60;
-20 < V_{sub} (V) ≤ 10; and
435 ≤T (°C) ≤ 550,
   or
0.1 ≤ P(Pa) ≤ 0.3;
T-S distance (mm) = 60;
-10 < V_{sub} (V) ≤ 15; and
515 < T (°C) < 550,
   or
0.1 ≤ P (Pa) ≤ 0.3;
T-S distance (mm) = 40;
-10 ≤ V_{sub} (V) ≤ 15; and
475 ≤ T (°C) ≤ 550,
   or
0.1 ≤ P (Pa) ≤ 0.3:
T-S distance (mm) = 40;
-10 < V_{sub} (V) ≤ 15; and
475 ≤T (°C) ≤ 550,
   or
0.1 ≤ P (Pa) ≤ 0.3;
T-S distance (mm) = 80;
-20 < V_{sub} (V) ≤ 15; and
525 ≤ T (°C) ≤ 550.

Note that when forming the piezoelectric film with the substrate potential V_{sub} of -20 V or lower and when forming the piezoelectric film at the temperature T above 550°C, the crystals form a pyrochlore structure, which prevents the adhesion of the films. Stable electric discharge is not obtained under the film formation pressure P below 0.1 Pa. Moreover, the substrate potential V_{sub} has a tolerance of approximately ±4 V, and the T-S distance has a tolerance of approximately 5 mm.

Under the same conditions, when the A-site is doped with anything other than Pb, the activation energy of the crystals changes, and consequently the inclination angle also changes.

### Inkjet recording apparatus

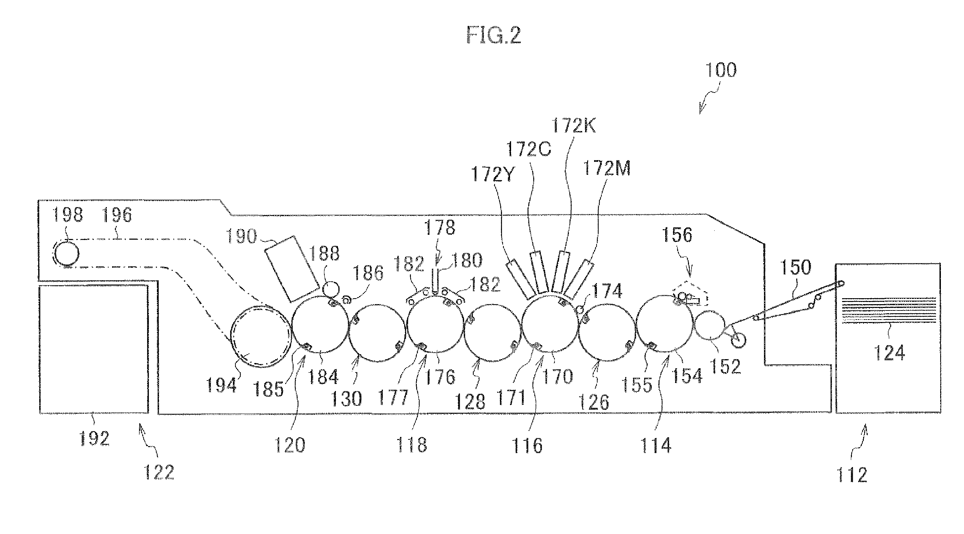

A configuration of an inkjet recording apparatus with the inkjet recording heads 3 (172M, 172K, 172C and 172Y) according to the embodiment of the present invention is described with reference to Fig. 2. Fig. 2 is a diagram showing the entire apparatus.

The inkjet recording apparatus 100 is of a direct-drawing type that forms a desired color image by depositing ink droplets of a plurality of colors from inkjet heads 172M, 172K, 172C and 172Y onto a recording medium 124 (often referred to as a "sheet" for convenience) that is held on a pressure drum (a drawing drum 170) of a drawing unit 116. The inkjet recording apparatus 100 is an on-demand type image forming apparatus employing a two-liquid reaction (aggregation) system for applying treatment liquid (aggregation treatment (liquid) to the recording medium 124 prior to depositing the ink droplets, and then making the treatment liquid react with the ink droplets to form an image on the recording medium 124.

As shown in Fig. 2, the inkjet recording apparatus 100 mainly has a sheet feeding unit 112, a treatment liquid application unit 114, the drawing unit 116, a drying unit 118, a fixing unit 120, and a discharge unit 122.

### <Sheet feeding unit>

The sheet feeding unit 112 is a mechanism for supplying the recording media 124 to the treatment liquid application unit 114. The recording media 124, sheets of paper, are stacked on the sheet feeding unit 112. The sheet feeding unit 112 is provided with a sheet tray 150 from which the recording media 124 are supplied, one by one, to the treatment liquid application unit 114.

### <Treatment liquid application unit>

The treatment liquid application unit 114 is a mechanism for applying the treatment liquid to a recording surface of the recording medium 124. The treatment liquid contains a color material aggregating agent for aggregating color materials (pigments in the present embodiment) of the ink deposited by the drawing unit 116. Contact between the treatment liquid and the ink facilitates separation of the ink into the color materials and solvent.

As shown in Fig. 2, the treatment liquid application unit 114 has a sheet feeding drum 152, treatment liquid drum 154, and treatment liquid application device 156. The treatment liquid drum 154 holds the recording medium 124, and rotates to convey the recording medium 124. The treatment liquid application device 156 is arranged on the outside of the treatment liquid drum 154 so as to face a circumference of the treatment liquid drum 154. The treatment liquid application device 156 is constituted of a treatment liquid container for storing the treatment liquid, an anilox roller that is partially submerged in the treatment liquid stored in the treatment liquid container, and a rubber roller that is pressed against the anilox roller and the recording medium 124 on the treatment liquid drum 154 to transfer the treatment liquid, obtained after measuring the amount thereof, to the recording medium 124. The treatment liquid application device 156 can coat the recording medium 124 with the treatment liquid while measuring the amount thereof.

The recording medium 124, applied with the treatment liquid in the treatment liquid application unit 114, is delivered from the treatment liquid drum 154 to the drawing drum 170 of the drawing unit 116 through an intermediate conveying unit 126.

### <Drawing unit>

The drawing unit 116 has the drawing drum (the second conveying body) 170, a sheet pressing roller 174, and the inkjet recording heads 172M, 172K, 172C and 172Y.

Each of the inkjet recording heads 172M, 172K, 172C and 172Y is preferably a full-line type inkjet recording head (inkjet head), the length of which corresponds to the maximum width of an image forming region on the recording medium 124. An ink ejection surface of each of the inkjet recording heads 172M, 172K, 172C and 172Y has a nozzle row in which a plurality of ink ejection nozzles are arranged over the entire width of the image forming region. Each of the inkjet recording heads 172M, 172K, 172C and 172Y is installed so as to extend in a direction perpendicular to a conveyance direction of the recording medium 124 (a rotation direction of the drawing drum 170).

The inkjet recording heads 172M, 172K, 172C and 172Y eject ink droplets of the corresponding colors to the recording surface of the recording medium 124 tightly held on the drawing drum 170. As a result, the ink droplets come into contact with the treatment liquid that has been applied to the recording surface in the treatment liquid application unit 114, and consequently the color materials (pigments) dispersed within the ink are aggregated, forming a color material aggregate. This prevents the color materials from flowing on the recording medium 124, and an image is formed on the recording surface of the recording medium 124.

The recording medium 124 on which the image has been formed in the drawing unit 116 is then delivered from the drawing drum 170 to a drying drum 176 of the drying unit 118 through an intermediate conveying unit 128.

### <Drying unit>

The drying unit 118 is a mechanism for drying the moisture contained in the solvent separated by the color material aggregating action. As shown in Fig. 2, the drying unit 118 has the drying drum (conveying body) 176 and a solvent drying device 178.

The solvent drying device 178, disposed so as to face an outer circumference of the drying drum 176. is constituted of IR (infrared) heaters 182 and a warm air jet nozzle 180 disposed between the IR heaters 182.

The temperature and volume of the warm air blown from the warm air jet nozzle 180 toward the recording medium 124, as well as the temperature of each IR heater 182, are adjusted appropriately so as to realize a variety of drying conditions.

The recording medium 124 that has been subjected to the drying process in the drying unit 118 is delivered from the drying drum 176 to a fixing drum 184 of the fixing unit 120 through an intermediate conveying unit 130.

### <Fixing unit>

The fixing unit 120 is constituted of the fixing drum 184, a halogen heater 186, a fixing roller 188, and an in-line sensor 190. When the fixing drum 184 rotates, the recording medium 124 is conveyed with its recording surface facing outward, and the recording surface is then preheated by the halogen heater 186, fixed by the fixing roller 188, and inspected by the in-line sensor 190.

The temperature of the halogen heater 186 is controlled to a predetermined temperature (180°C, for example), and the recording medium 124 is preheated at this temperature. The fixing roller 188 is a roller member that adheres self-dispersible thermoplastic resin particles in the dried ink to each other by applying heat and pressure to the dried ink, in order to form the ink into a film. The fixing roller 188 is configured to apply heat and pressure to the recording medium 124. The in-line sensor 190 is a measuring device for measuring a check pattern, the amount of moisture, the surface temperature, glossiness and the like of the image fixed to the recording medium 124. A CCD line sensor can be employed as the in-line sensor 190.

### <Discharge unit>

The discharge unit 122 is arranged following the fixing unit 120. The discharge unit 122 has a discharge tray 192. Between the discharge tray 192 and the fixing drum 184 of the fixing unit 120 there are arranged a delivery drum 194, conveying belt 196, and stretching roller 198 so as to face the discharge tray 192 and the fixing drum 184. The recording medium 124 is fed to the conveying belt 196 by the delivery drum 194 and then discharged to the discharge tray 192.

Although Fig. 2 illustrates the drum conveyance type inkjet recording apparatus, the present invention is not limited thereto and can also be used in a belt conveyance type inkjet recording apparatus and the like.

### EXAMPLES

The present invention is described in further detail using examples below; however, the present invention is not limited thereto.

Piezoelectric films were formed using a sputtering method. The inclination angle of the normal of the (100) plane of the crystal constituting the piezoelectric films was controlled by controlling the energy of the sputtered particles that reach the substrate, i.e., by appropriately setting the film formation pressure, the target-substrate distance (T-S), the substrate voltage Vs, and the substrate temperature.

The inclination angle of the normal of the (100) plane of the crystal was further controlled by changing the component occupying the A-site in a target.

### <Example 1>

A Ti film with a thickness of 30 nm and an Ir film with a thickness of 150 nm were sequentially formed on an SOI substrate to obtain a lower electrode, by using the sputtering method at the substrate temperature of 350°C. A Nb-doped PZT piezoelectric film with a thickness of 4 µm was formed on this lower electrode. This film formation was performed under the following conditions.

### «Film Formation Conditions»

### Film formation apparatus: RF sputtering apparatus

Target: Pb_{1.3}((Zr_{0.52}Ti_{0.48})_{0.88}Nb_{0.12})O₃ sintered body (the amount of Nb occupying the B-site: 12 mol%)
Substrate temperature: 475°C
Target-substrate (T-S) distance: 60 mm
Film formation pressure: 0.30 Pa
Film formation gas: Ar/O₂ = 97.5/2.5 (molar ratio)
Substrate potential V_{sub} = -12 V
The substrate potential V_{sub} was set at +25 V for five minutes after starting the film formation in order to provide a perovskite layer as an initial layer.

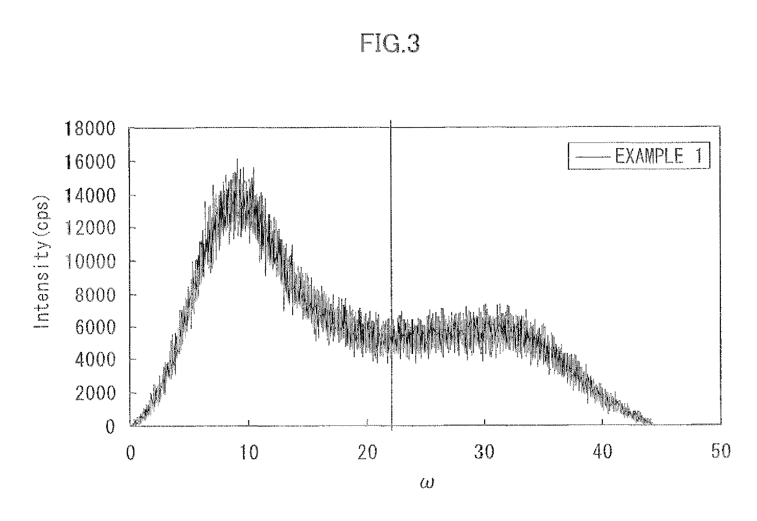

As a result of performing the XRD measurement to examine the orientation of the piezoelectric film after completion of the film formation, the film had a (100) priority orientation. Subsequently, 2θ was set at an angle at which a (200) peak appears, to perform ω scanning in the XRD measurement. The results are shown in Fig. 3. In Fig. 3, 2θ was fixed at 44.4° at which the perovskite PZT (200) plane peak appears, and then the scanning was performed. The diagram shows that the (100) plane is parallel to the substrate surface when ω is 22.2° (i.e., the normal of the (100) plane is parallel to the normal of the substrate surface), and the angle of (ω - 22.2°) represents the inclination angle of the normal of the (100) plane. According to Fig. 3, it was confirmed that the normal of the (200) plane (which is the same with the normal of the (100) plane) was inclined by 12.6° with respect to the normal of the substrate surface. The inclination angle of the normal of (200) plane can also be measured through Φ scanning where a specimen is rotated, as well as pole figure measurement.

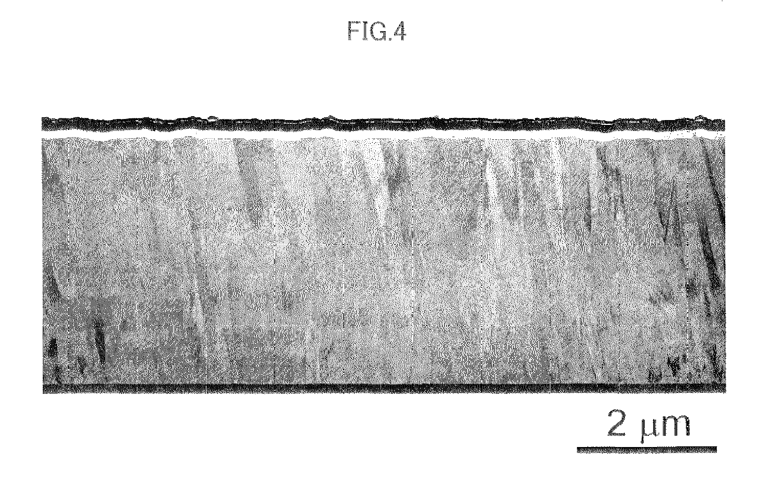

Fig. 4 shows a TEM (transmission electron microscopy) cross-sectional image of the resultant piezoelectric film. The image was obtained through observation of an ultra-thinning process performed on the piezoelectric film using an ion milling process. The film had a continuous columnar structure, and no grain boundary caused by irregular lamination was observed in the normal direction with respect to the film thickness.

Subsequently, a Pt/Ti upper electrode (Pt: 150 nm-thick, Ti: 30 nm-thick) was formed through vapor deposition on the resultant piezoelectric film (where Ti serves as an adhesion layer and Pt mainly serves as the electrode), and thus obtained material was subjected to predetermined patterning through lithography. Then, an open pool structure was formed by processing the rear surface of the substrate to produce an inkjet recording head. The piezoelectric constant d₃₁ of the produced inkjet recording head was then measured.

The driving durability of the piezoelectric film was evaluated through experiment in which the inkjet recording head was driven under conditions of 100 kHz and 25 Vp-p sine wave in an atmosphere with the temperature of 40°C and the relative humidity of 80%. The experiment was ended as soon as insulation breakdown or displacement deterioration was observed in the piezoelectric film, and the driving durability of the piezoelectric film was evaluated according to the following criteria based on the number of times the inkjet recording head was driven:
Good: 1 × 10¹¹ cycles ≤ Driving durability;
Fair: 1 × 10⁹ cycles ≤ Driving durability < 1 × 10¹¹ cycles; and
Poor: Driving durability < 1 × 10⁹ cycles.

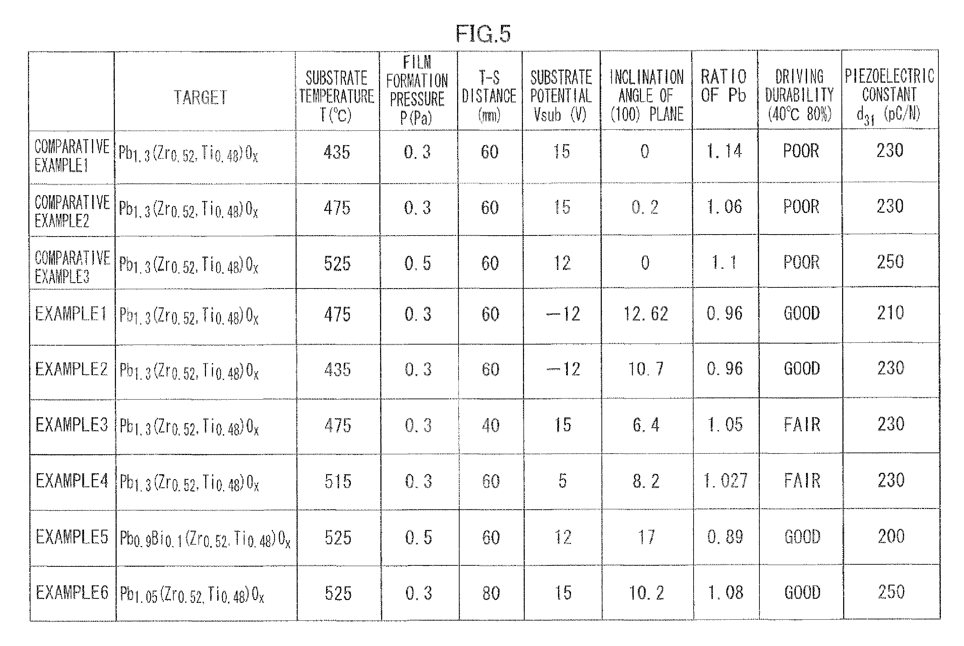

Moreover, the amount of Pb, a ratio obtained when the sum of the B-site elements is 1, was measured by X-ray fluorescence analysis (XRF). The results are shown in Fig. 5.

Even after the inkjet recording head was driven for 1 × 10¹¹ cycles, Example 1 showed no changes and thus had good durability.

### <Examples 2 to 6>

The same method as that of Example 1 was used for producing piezoelectric films and inkjet recording heads under the conditions described in Fig. 5, and the obtained piezoelectric films and inkjet recording heads were evaluated.

### <Comparative Example 1>

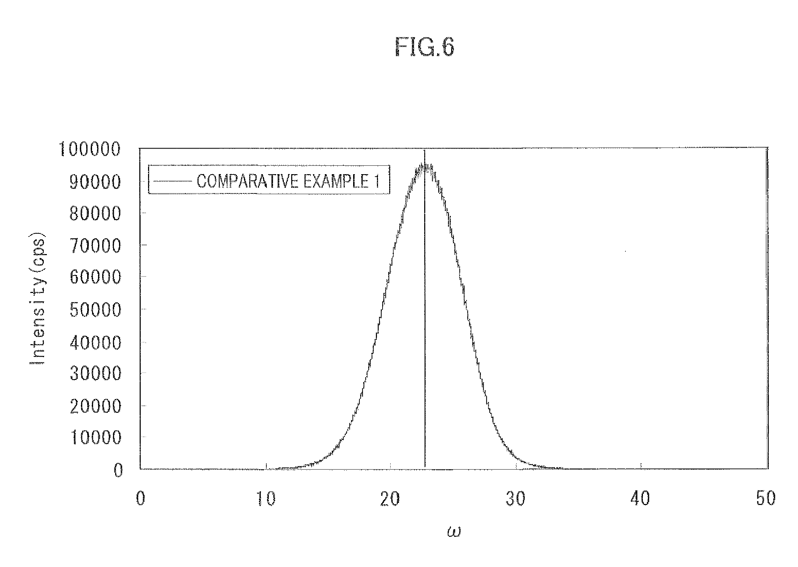

The same method as that of Example I was used for producing a piezoelectric film under the conditions described in Fig. 5. As a result of performing the XRD measurement to examine the orientation of the piezoelectric film after completion of the film formation, the film had a (100) priority orientation. Subsequently, 2θ was set at an angle at which a (200) peak appears, to perform ω scanning. The results are shown in Fig. 6. According to Fig. 6, it was confirmed that the inclination angle of the (200) plane was 0°.

Subsequently, an inkjet recording head was produced in the same manner as Example 1. As a result of the durability test, insulation breakdown occurred when the inkjet recording head was driven for 3 x 10⁸ cycles.

### <Comparative Examples 2 and 3>

The same method as that of Comparative Example 1 was used for producing piezoelectric films and inkjet recording heads under the conditions described in Fig. 5, and the obtained piezoelectric films and inkjet recording heads were evaluated.

According to Fig. 5, high driving durability was realized by inclining the (100) plane by 6° or more. The durability dropped when the amount of Pb was 1.10 or above.

### <Comparative Example 4>

A Ti film with a thickness of 30 nm and an Ir film with a thickness of 150 nm were sequentially formed on an SOI substrate to obtain a lower electrode, by using the sputtering method at the substrate temperature of 350°C. A piezoelectric film was formed on this lower electrode by means of a sol-gelation process.

More specifically, coating liquid containing Pb_{1.05}(Zr_{0.46}Ti_{0.42}Nb_{0.12})Oₓ (concentration: 0.5 mol/1) was applied onto the above-mentioned lower electrode by using a spin-coating process for 5 seconds at 500 rotations per minute and then 15 seconds at 2000 rotations per minute, to obtain a substantially constant thickness. After coating the lower electrode with the coating liquid, the lower electrode was dried at 250°C for approximately 5 minutes. After this drying step, the lower electrode was subjected to defatting for 10 minutes in the atmosphere with the temperature of 400°C. The series of coating, drying, and defatting steps was repeated five times to obtain five piezoelectric layers. Subsequently, the laminated five layers were heated at 800°C for 10 minutes through RTA (rapid thermal annealing) heat treatment to promote crystallization of the piezoelectric material and to improve properties of the piezoelectric material. As a result of repeating the series of five-layer lamination and heating steps one more time to obtain a PZT film having the thickness of 2 µm or more, cracks were generated in the entire PZT film when the 10th layer was heated at 800°C. Therefore, the evaluation could not be performed.

Comparative Example 4 confirmed that it is difficult to form a thick piezoelectric film by means of the sol-gelation process.

It should be understood that there is no intention to limit the invention to the specific forms disclosed, but on the contrary, the invention is to cover all modifications, alternate constructions and equivalents falling within the scope of the invention as expressed in the appended claims.

## Claims

1. A piezoelectric film (13) which is formed on a surface of a substrate (12) by a vapor deposition process without generating grain boundaries which are substantially parallel to the surface of the substrate (12) and are caused by lamination, wherein a normal of a (100) plane of each of crystals constituting the piezoelectric film (13) is inclined from a normal of the surface of the substrate (12) by an angle of not smaller than 6° and not larger than 36°.

2. The piezoelectric film (13) as defined in claim 1. wherein a thickness of the piezoelectric film (13) is not smaller than 2 µm and not larger than 20 µm.

3. The piezoelectric film (13) as defined in claim 1 or 2, wherein the piezoelectric film (13) has a columnar crystal structure extending in a thickness direction of the piezoelectric film (13).

4. The piezoelectric film (13) as defined in any of claims 1 to 3, wherein the piezoelectric film (13) has a piezoelectric constant d₃₁ of not smaller than 200 pC/N.

5. The piezoelectric film (13) as defined in any of claims 1 to 4, wherein the piezoelectric film (13) includes at least one perovskite oxide represented by ABO₃ where A represents at least one element which occupies an A-site and is selected from a group consisting of Pb, Ba, La, Sr, Bi, Li, Na, Ca, Cd, Mg and K; B represents at least one element which occupies a B-site and is selected from a group consisting of Ti, Zr, V, Nb, Ta, Sb, Cr, Mo, W, Mn, Sc, Co, Cu, In, Sn, Ga, Zn, Cd, Fe and Ni; O represents oxygen; and a molar ratio of A:B:O is within a range where a perovskite structure is obtained and 1:1:3 is a standard.

6. The piezoelectric film (13) as defined in any of claims 1 to 4, wherein the piezoelectric film (13) includes at least one perovskite oxide represented by ABO₃, where A represents at least one element which occupies an A-site and includes Pb; B represents at least one element which occupies a B-site and is selected from a group consisting of Ti, Zr, V, Nb, Ta, Sb, Cr, Mo, W, Mn, Sc, Co, Cu, In, Sn, Ga, Zn, Cd, Fe and Ni; O represents oxygen; and a molar ratio of A:B:O is within a range where a perovskite structure is obtained and 1:1:3 is a standard.

7. The piezoelectric film (13) as defined in any of claims I to 4, wherein the piezoelectric film (13) includes at least one perovskite oxide represented by Aₐ(Zrₓ, Ti_{y}, M_{b-x-y})_{b}O_{c,} where A represents at least one element which occupies an A-site and includes Pb; M represents at least one metal element; 0 < x < b, 0 < y < b, 0 ≤ (b - x - y); and a ratio of a:b:c is within a range where a perovskite structure is obtained and 1:1:3 is a standard.

8. The piezoelectric film (13) as defined in claim 7, wherein the Pb component a occupying the A-site is less than 1.10.

9. The piezoelectric film (13) as defined in any of claims 1 to 8, wherein the vapor deposition process uses plasma.

10. The piezoelectric film (13) as defined in any of claims 1 to 9, wherein the vapor deposition process includes a sputtering process.

11. A piezoelectric device (1), comprising:
the piezoelectric film (13) as defined in any of claims 1 to 10; and
electrodes (12, 14) through which an electric field is applied to the piezoelectric film (13).

12. A liquid ejection apparatus (3), comprising:
the piezoelectric device (1) as defined in claim 11; and
a liquid ejection member (20) which is arranged adjacent to the piezoelectric device (1) and includes:
a liquid storing chamber (21) which stores liquid; and
a liquid ejection port (22) through which the liquid is ejected from the liquid storing chamber (21) in response to an application of the electric field to the piezoelectric film (13).

13. A method of producing a piezoelectric film (13), comprising the step of forming a piezoelectric film (13) on a surface of a substrate (12) by a vapor deposition process, the piezoelectric film (13) having a columnar crystal structure in which a normal of a (100) plane of each of crystals constituting the piezoelectric film (13) is inclined from a normal of the surface of the substrate (12) by an angle of not smaller than 6° and not larger than 36°.

14. The method as defined in claim 13, wherein the vapor deposition process uses plasma.

15. The method as defined in claim 13 or 14, wherein the vapor deposition process includes a sputtering process.
